# EUROPEAN PATENT SPECIFICATION

(11) **EP 3 675 303 B1**
(45) Date of publication and mention of the grant of the patent: **11.11.2026**
(21) Application number: 18858998.0
(22) Date of filing: 21.09.2018
(51) Int. Cl.: H02H 7/18, H02H 3/08, G01R 19/165, H02H 3/087, H02J 7/60, H02J 7/62

(54) **POWER SOURCE PROTECTION APPARATUS AND TERMINAL USING SAME**
STROMVERSORGUNGSSCHUTZVORRICHTUNG UND ENDGERÄT MIT VERWENDUNG DAVON
APPAREIL DE PROTECTION D'ALIMENTATION ÉLECTRIQUE ET TERMINAL FAISANT APPEL À CELUI-CI

(30) Priority: 23.09.2017 CN 201710870503
(43) Date of publication of application: 01.07.2020
(73) Proprietor: Huawei Technologies Co., Ltd., Longgang District Shenzhen, Guangdong 518129 (CN)
(72) Inventor: LIU, Xinyu, Shenzhen, Guangdong 518129 (CN); LIU, Yanding, Shenzhen, Guangdong 518129 (CN); LIU, Ce, Shenzhen, Guangdong 518129 (CN); WANG, Pinghua, Shenzhen, Guangdong 518129 (CN); CAO, Yong, Shenzhen, Guangdong 518129 (CN)
(74) Representative: Goddar, Heinz J.
(86) International application number: PCT/CN2018/106907
(87) International publication number: WO 2019/057144

(56) References cited:
- CN-A- 102 208 802
- CN-A- 103 529 276
- CN-A- 103 575 964
- CN-A- 103 633 617
- CN-A- 105 846 493
- CN-A- 105 846 493
- CN-A- 107 579 508
- CN-A- 108 063 428
- JP-A- 2004 282 894
- JP-A- 2010 181 351
- US-A1- 2005 189 981

## Description

### TECHNICAL FIELD

Embodiments of the present invention relate to the circuit field, and more specifically, to a power protection apparatus and a terminal using the apparatus.

### BACKGROUND

Currently, fast charge of a terminal has become a common customer need. A fast charge technology used by the terminal has become a current hot technology. However, heat emitted due to fast charge is also a problem of the whole industry. When a charge current doubles, an amount of heat caused by same charge circuit impedance increases by three times.

When lithium-ion batteries used by some common terminals are used, a protection circuit packaged inside the battery and serially connected to an electrochemical cell is needed to monitor charge overvoltage, discharge undervoltage, charge overcurrent, and discharge overcurrent of the lithium-ion battery. For discharge overcurrent, not only a requirement for LPS (Limited power sources) certification in related specifications needs to be satisfied, that is, when a current is 8 amperes, a semiconductor switch (MOS) transistor needs to be turned off within five seconds to implement power-off protection, but also a requirement needs to be satisfied that a mobile phone is not powered off within 60 seconds when a pulse load current is 5 amperes, within five seconds when a pulse load current is 6 amperes, or within two seconds when a pulse load current is 7 amperes.

In existing methods for detecting a current of a battery protection circuit, a common method is: performing overcurrent detection by using impedance of a resistor of an MOS transistor of a charge and discharge circuit, and triggering an overcurrent detection comparator inside a protection IC of a lithium-ion battery by using a voltage drop formed after a current passes through the resistor of the MOS transistor of the discharge and discharge circuit. However, the impedance of the resistor of the MOS transistor is not a constant value and varies with conditions. When fast charge is implemented by using a high current, breakover voltages at both terminals of the MOS transistor are relatively high and change in a relatively large range. As a result, the impedance of the resistor of the MOS transistor also changes greatly, and a high-precision requirement cannot be satisfied.

In the existing methods for detecting a current of a battery protection circuit, another common method is: disposing a dedicated current sampling resistor for a charge and discharge circuit, performing overcurrent detection by using the current sampling resistor, and triggering an overcurrent detection comparator inside a protection IC of a battery by using a voltage drop formed after a current passes through the current sampling resistor RS of the charge and discharge circuit.

However, because the additional current sampling resistor is introduced, impedance of the charge and discharge circuit increases. When fast charge is implemented by using a high current, the current sampling resistor also generates heat, causing temperature of the charge and discharge circuit to increase remarkably.

Therefore, currently, when fast charge of a battery is implemented by using a high current, there lacks an effective solution to ensure efficiently high overcurrent detection precision without causing extra through-current impedance of a charge and discharge circuit.
JP 2010/181351 A describes a current detection circuit with a bidirectional switch. The bidirectional main switch is provided with a charge current detection circuit and a discharge current detection circuit, which are formed of bidirectional mirror switches, sensing resistors, and operational amplifiers.
US 2005/189981 A1 describes a bidirectional main switch including two main switches and a bidirectional mirror switch including two mirror switches, so as to allow a small current (a mirror current) to flow therein in a specified ratio to a current in the main switches; and an operational amplifier forming a feedback amplifying circuit, being connected between the end of the bidirectional main switch and the end of the bidirectional mirror switch, and allowing the mirror current to flow in the bidirectional mirror switch through a sensing resistor Rs so as to equalize voltages at the ends of the two bidirectional switches, with which the mirror current, consequently a battery charge and discharge current, is detected from a voltage across the sensing resistor.
CN 105 846 493 A further relates to overcurrent detection and protection circuits for batteries.

### SUMMARY

Embodiments of the present invention provide a power protection apparatus and a terminal using the apparatus, to resolve a problem that through-current circuit impedance is too high and overcurrent detection precision is not high enough during high-current fast charge of a battery in a power protection apparatus.
The invention is defined by the independent claims. Advantageous embodiments of the invention are given in the dependent claims.

According to a first aspect, an embodiment of the present invention provides a battery protection apparatus power protection apparatus. The apparatus is configured to protect an electrochemical cell connected to a load, and includes a protection IC, a switching transistor group, and a sampling resistor. The protection IC includes two power input terminals respectively connected to positive and negative electrodes of the electrochemical cell, and an operational amplifier, where the operational amplifier includes a positive input pin, a negative input pin, and an output pin. The switching transistor group is connected between the negative electrode of the electrochemical cell and the load, and is configured to control turn-on and turn-off of a charge and discharge circuit of the electrochemical cell; the switching transistor group includes a main circuit and a sampling circuit; and the switching transistor group includes a first connection terminal connected to the negative electrode of the electrochemical cell, a second connection terminal connected to the load, a least one control terminal, a sampling circuit detection terminal, and a main circuit detection terminal, where the control terminal is connected to the protection IC, and is configured to receive a control signal of the protection IC to control turn-off of the switching transistor group to implement protection against an abnormality of the electrochemical cell. The sampling detection resistor Rs is serially connected between the sampling circuit detection terminal and the output pin, and is configured to detect a current of the sampling circuit. The main circuit detection terminal is connected to the positive input pin, the sampling circuit detection terminal is connected to the negative input pin, and the operational amplifier is mainly configured to enable a voltage of a main circuit part of the switching transistor group to be the same as a voltage at a connection point between the main circuit part and the operational amplifier, so that a current passing through the main circuit is equally proportional to a current passing through the sampling circuit. Equivalently, the first connection terminal and the second connection terminal are respectively connected to a charge-specific input terminal and output terminal of the main circuit part of the switching transistor group, or to a discharge-specific output terminal and input terminal of the main circuit part of the switching transistor group. In other words, the main circuit part of the switching transistor group is a part of the charge and discharge circuit of the electrochemical cell. A current in the charge and discharge circuit passes through the main circuit mainly through the first connection terminal and the second connection terminal.

According to examples, which are not part of the present invention, another component may be used to enable a voltage of the sampling circuit detection terminal to be the same as a voltage of the main circuit detection terminal.

The protection apparatus mainly performs, by using a current imaging function of a detection field effect transistor of the switching transistor group, imaging on a current in the main through-current circuit based on a given proportional coefficient 1/K to obtain a very low current. The protection IC detects the very low current obtained through imaging, then multiplies the very low current by a proportional coefficient K, to obtain a value of the current in the main through-current circuit, and finally determines, based on the value, whether charge overcurrent or discharge overcurrent occurs. Further, the protection IC turns off a charge switch or a discharge switch to implement a function of charge overcurrent protection or discharge overcurrent protection.

With reference to the first aspect, in a first possible implementation of the first aspect, the operational amplifier is configured to enable the negative input pin and the positive input pin to have a same potential, that is, enable the sampling circuit detection terminal and the main circuit detection terminal of the switching transistor group to have a same potential, so that the current passing through the sampling circuit is equally proportional to the current passing through the main circuit, where a current passing through the first connection terminal and the second connection terminal is equal to the current of the main circuit.

According to the invention, the switching transistor group includes (X+KX) switching transistor units that are connected in parallel; X switching transistor units are connected in parallel to constitute the sampling circuit; KX transistors are connected in parallel to constitute the main circuit; and a ratio of the current passing through the sampling circuit to the current passing through the main circuit is equal to a ratio of a quantity of switching transistor units of the sampling circuit to a quantity of switching transistor units of the main circuit, that is, is equal to 1:K, where X is an integer greater than or equal to 1, K is greater than 1, and KX is an integer.

With reference to the first aspect, in a second possible implementation of the first aspect, the switching transistor group includes sampling circuit output terminals SS₁ and SS₂, and main circuit detection output terminals S₁ₖ and S₂ₖ, where the S₁ₖ is connected to the positive input pin of the operational amplifier, the SS₁ is connected to both the negative input pin and the output pin of the operational amplifier, and the sampling detection resistor Rs is serially connected between the SS₁ and the output pin of the operational amplifier.

With reference to the second implementation of the first aspect, in a third possible implementation of the first aspect, the protection IC further includes a secondary operational amplifier, the S₂ₖ is connected to a positive input pin of the secondary operational amplifier, the SS₂ is connected to both a negative input pin and an output pin of the secondary operational amplifier, and the power protection apparatus further includes a sampling detection resistor R2 that is serially connected between the SS₂ and the output pin of the secondary operational amplifier.

With reference to the first aspect, in a fourth possible implementation of the first aspect, the sampling circuit detection terminal includes sampling circuit output terminals SS₁ and SS₂, and sampling detection output terminals SS₁ₖ and SS₂ₖ, and the main circuit detection terminal includes main circuit detection output terminals S₁ₖ and S₂ₖ, where the S₂ₖ is connected to the positive input pin of a operational amplifier, the SS₁ is connected to the output pin of the operational amplifier, the SS₁ₖ is connected to the negative input pin of the operational amplifier, and the sampling detection resistor Rs is serially connected between the SS₁ and the output pin of the operational amplifier.

With reference to the fourth implementation of the first aspect, in a fifth possible implementation of the first aspect, the protection IC further includes a secondary operational amplifier, the S₂ₖ is connected to a positive input pin of the secondary operational amplifier, the SS₂ is connected to an output pin of the secondary operational amplifier, the SS₂ₖ is connected to a negative input pin of the secondary operational amplifier, and the power protection apparatus further includes a sampling detection resistor R2 that is serially connected between the SS₂ and the output pin of the secondary operational amplifier.

With reference to the fourth or fifth implementation of the first aspect, in a sixth possible implementation of the first aspect, each switching transistor unit includes a first switching transistor Sa and a second switching transistor Sb that is serially connected to the Sa reversely, each Sa or Sb is connected to a diode D1 in parallel, the Sa is a discharge switching transistor and the Sb is a charge switching transistor, the X switching transistor units are connected in parallel to constitute the sampling circuit, and the KX switching transistor units are connected in parallel to constitute the main circuit.

With reference to the sixth implementation of the first aspect, in a seventh possible implementation of the first aspect, D electrodes of all Sa's and Sb's are connected together, G electrodes of all Sa's of the (X+KX) switching transistor units are connected together to constitute a discharge control terminal G1, G electrodes of all Sb's of the (X+KX) switching transistor units are connected together to constitute a charge control terminal G2, S electrodes of all Sa's of the X switching transistor units constituting the sampling circuit are connected to a same pin to constitute the sampling circuit output terminal SS₁, S electrodes of all Sb's of the X switching transistor units are connected to a same pin to constitute the sampling circuit output terminal SS₂, S electrodes of all Sa's of the KX switching transistor units constituting the main circuit are connected to a same pin to constitute the first connection terminal S₁ of the switching transistor group, and S electrodes of all Sb's of the X switching transistor units are connected to a same pin to constitute the second connection terminal S₂ of the switching transistor group.

According to the invention, the SS₁ₖ is constituted by directly connecting the S electrodes on wafers of all the Sa's of the X switching transistor units of the sampling circuit by using a high-conductivity metal wire, the SS₂ₖ is constituted by directly connecting the S electrodes on wafers of all the Sb's of the X switching transistor units of the sampling circuit by using a high-conductivity metal, the detection output terminal S₁ₖ of the main circuit is constituted by directly connecting the S electrodes on wafers of all the Sa's of the KX switching transistor units of the main circuit by using a high-conductivity metal wire, and the S₂ₖ is constituted by directly connecting the S electrodes on wafers of all the Sb's of the KX switching transistor units of the main circuit by using a high-conductivity metal.

With reference to any one of the implementations of the first aspect, in a ninth possible implementation of the first aspect, the at least one control terminal includes the discharge control terminal G1 configured to control turn-off of the switching transistor group during discharge, and the charge control terminal G2 configured to control turn-off of the switching transistor group during charge, and at least one charge and discharge protection terminal of the protection IC includes a discharge protection terminal DO connected to the discharge control terminal G1, and a charge protection terminal CO connected to the charge control terminal G2.

In this embodiment of the present invention, charge overvoltage protection, discharge undervoltage protection, charge overcurrent protection, and discharge overcurrent protection of a battery are implemented by using the switching transistor group and the protection IC. A current imaging function of a detection field effect transistor is used to perform imaging on a current in the main through-current circuit based on a given proportional coefficient 1/K to obtain a very low current. The protection IC detects the very low current obtained through imaging, and then multiplies the very low current by a proportional coefficient K, to obtain a value of the current in the main through-current circuit. The sampling detection resistor Rs is serially connected between the sampling detection output terminal and the output pin, and is not disposed on the charge and discharge circuit. In addition, a detection current passing through the sampling detection resistor Rs is 1/K of the current in the charge and discharge circuit, far less than the current in the charge and discharge circuit. Therefore, heat generated by the sampling detection resistor Rs is very small, and basically has no actual impact on temperature of the charge and discharge circuit.

According to another aspect, an embodiment of the present invention provides a terminal, including a charge connector, a charge management chip, a battery, and a load, where the charge connector is configured to connect to a charge cable, the charge management chip is connected between the charge connector and the battery and is configured to control a charge process of the battery, the battery is configured to supply power to the load, and the battery includes an electrochemical cell, and the power protection apparatus according to any implementations of the first aspect, where the power protection apparatus is configured to protect the electrochemical cell.

In the embodiments of the present invention, charge overvoltage protection, discharge undervoltage protection, charge overcurrent protection, and discharge overcurrent protection of a battery are implemented by using the switching transistor group and the protection IC. A current imaging function of a detection field effect transistor is used to perform imaging on a current in the main through-current circuit based on a given proportional coefficient 1/K to obtain a very low current. The protection IC of the lithium-ion battery detects the very low current obtained through imaging, and then multiplies the very low current by a proportional coefficient K, to obtain a value of the current in the main through-current circuit. The sampling detection resistor Rs is serially connected between the sampling circuit detection output terminal and the output pin, and is not disposed on the charge and discharge circuit. In addition, a detection current passing through the sampling detection resistor Rs is 1/K of the current in the charge and discharge circuit, far less than the current in the charge and discharge circuit. Therefore, heat generated by the sampling detection resistor Rs is very small, and basically has no actual impact on temperature of the charge and discharge circuit.

In addition, a current passing through the sampling circuit detection terminal and the sampling detection resistor Rs is far less than a current passing through the main circuit of the switching transistor group and the charge and discharge circuit. Therefore, although a value of the sampling detection resistor Rs is scores of ohms to hundreds of ohms, no loss having actual impact is generated on the sampling detection resistor Rs. In addition, the resistance value of the sampling detection resistor Rs is not affected by a factor such as heating, and therefore a proper resistance value can be selected to achieve highest detection precision.

Finally, whether charge overcurrent or discharge overcurrent occurs is determined based on the detection current, and then the protection IC turns off a charge switch or a discharge switch to implement a function of charge overcurrent protection or discharge overcurrent protection. In this way, high-precision charge overcurrent protection and discharge overcurrent protection can be implemented without disposing a current sampling resistor on a charge and discharge through-current circuit of a terminal, thereby greatly reducing impedance of the through-current circuit and effectively reducing heat emitted by the charge and discharge circuit.

### BRIEF DESCRIPTION OF DRAWINGS

FIG. 1 is a diagram of an application scenario according to an embodiment of the present invention;
FIG. 2 is a circuit diagram of a power protection apparatus according an example, which is not part of the invention;
FIG. 3 is another circuit diagram of a power protection apparatus according to Embodiment 1 of the present invention;
FIG. 4 is a schematic structural diagram of a switching transistor group according to an embodiment of the present invention;
FIG. 5 is a schematic structural diagram of another switching transistor group according to an embodiment of the present invention;
FIG. 6 is a schematic structural diagram of still another switching transistor group according to an embodiment of the present invention;
FIG. 7 is a circuit diagram of a power protection apparatus according an example, which is not part of the invention; and
FIG. 8 is a circuit diagram of a power protection apparatus according to Embodiment 2 of the present invention.

### DESCRIPTION OF EMBODIMENTS

The following clearly describes the technical solutions in the embodiments of the present invention with reference to the accompanying drawings in the embodiments of the present invention.

A power protection apparatus in the embodiments of the present invention is mainly applicable to various electronic products having a rechargeable battery, and especially applicable to some portable devices, such as terminal products like mobile phones, tablet computers, notebook computers, and various wearable devices. This type of terminal that requires charging requires a power protection apparatus to implement power-off protection in cases such as overvoltage, overcurrent, and over-charge. Otherwise, an electrochemical cell in a battery is damaged, and even a serious consequence is caused, for example, the electrochemical cell is exploded. A battery in the embodiments of the present invention includes a rechargeable-battery protection circuit or apparatus and an electrochemical cell. The electrochemical cell is an electric energy storage carrier, for example, a dry cell.

For ease of description, all electronic products having a rechargeable battery are referred to as terminals in the following.

The power protection apparatus in the embodiments of the present invention may be used as a lithium-ion battery protection circuit of a consumer electronic device, for example, a lithium-ion battery protection circuit of a mobile phone, a wearable device like a watch, a notebook computer, a tablet computer, or the like. The lithium-ion battery protection circuit is located on an independent printed circuit board (PCB), and the PCB is connected to an electrochemical cell of a lithium-ion battery. A rechargeable battery in a consumer electronic product usually is a lithium-ion battery package including a PCB carrying a lithium-ion battery protection circuit, an electrochemical cell of a lithium-ion battery, and a housing, and is used to supply power to the consumer electronic device.

The power protection apparatus in the embodiments of the present invention mainly includes an MOS transistor group and a protection integrated circuit (IC). The MOS transistor group and the protection integrated circuit are used together to implement charge overvoltage protection, discharge undervoltage protection, charge overcurrent protection, and discharge overcurrent protection of a battery. An advantage is that high-precision charge overcurrent protection and discharge overcurrent protection can be implemented without disposing a current sampling resistor on a charge and discharge through-current circuit of a terminal, thereby greatly reducing impedance of the through-current circuit and reducing heat. The power protection apparatus mainly performs, by using a current imaging function of a detection field effect transistor, imaging on a current in a main through-current circuit based on a given proportional coefficient 1/K to obtain a very low current. The protection IC of a lithium-ion battery detects the very low current obtained through imaging, then multiplies the very low current by a proportional coefficient K, to obtain a value of the current in the main through-current circuit, and finally determines, based on the value, whether charge overcurrent or discharge overcurrent occurs. Further, the protection IC turns off a charge switch or a discharge switch to implement a function of charge overcurrent protection or discharge overcurrent protection.

A current imaging principle of the detection field effect transistor used in the embodiments of the present invention is: Small switching transistor units inside a switching transistor group are allocated on a same wafer based on a given ratio, for example, the switching transistor units are allocated based on a ratio of 1X/1000X, where 1000X switching transistor units in the ratio of 1:1000 are used for a through-current function of a main circuit, and 1X switching transistor units in the ratio of 1:1000 are used for current sampling. When voltages between output pins of the switching transistor units used for the through-current function of the main circuit and the switching transistor units used for current sampling are equal, because temperature features are consistent on the same wafer, an overall ratio of impedance of the switching transistor units used for the through-current function of the main circuit to impedance of the switching transistor units used for current sampling should also be 1:1000. In addition, because voltages at both ends of the switching transistor units used for the through-current function of the main circuit and the switching transistor units used for current sampling are also equal, a ratio of a current passing through the switching transistor units used for the through-current function of the main circuit to a current passing through the switching transistor units used for current sampling is 1000: 1.

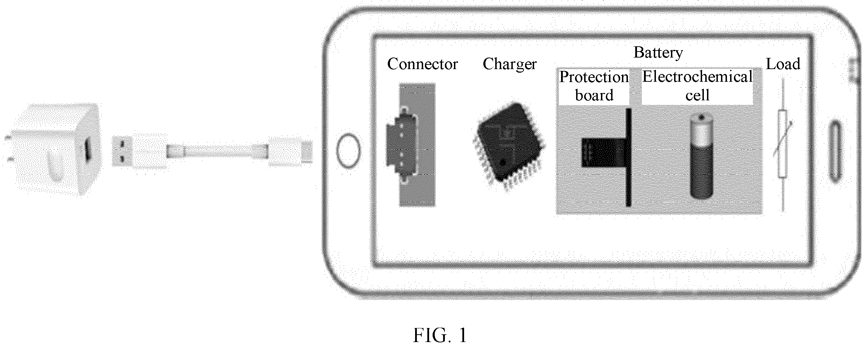

As shown in FIG. 1, a terminal using the power protection apparatus in an embodiment of the present invention includes a connector connected to a charger by using a cable, a charge management chip, a power protection apparatus, an electrochemical cell of a battery, and a load. The power protection apparatus is a battery protection board. The load may be any electrically-driven component in the terminal, for example, a display, a communications module, a processor, a memory, a sensor, or a speaker.

During charge of the terminal, a current flow direction is: the charger→the cable→the connector→the charge management chip→the power protection apparatus→the electrochemical cell. During discharge, a current flow direction is: the electrochemical cell→the protection board→the load.

In a charge process of the terminal, charge currents of the charger, the charge management chip, and the protection board are limited. When the charger, or the charge management chip, or both fail, charge overcurrent protection of the electrochemical cell is implemented by the protection board. When charge overcurrent is detected, a switch component on the protection board is disconnected to cut off a charge path.

In a discharge process, a discharge current of the protection board is limited. When the load is abnormal, for example, the load is short-circuited, discharge overcurrent protection of the lithium-ion battery is implemented by the protection board. When discharge overcurrent is detected, a switch component on the protection board is disconnected to cut off a discharge path.

### Embodiment 1

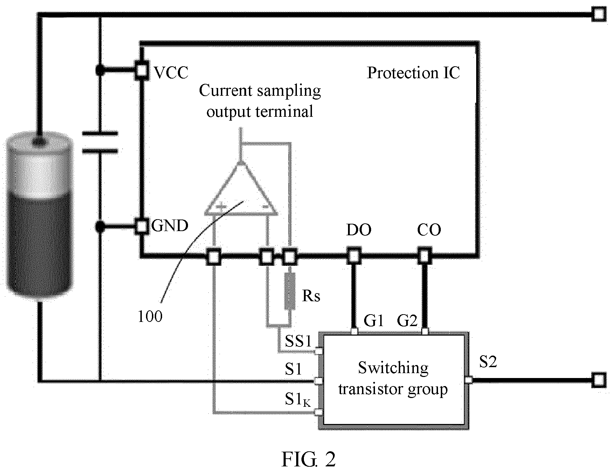

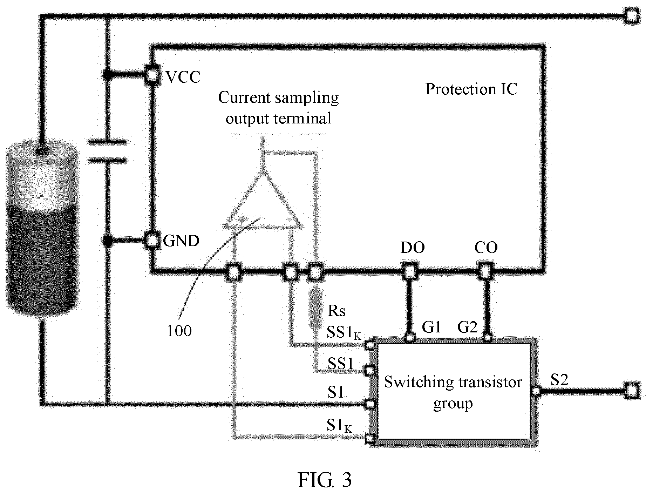

Referring to FIG. 2 and FIG. 3, a terminal having a charge protection function includes an electrochemical cell, a power protection apparatus, and a load that is powered by using the electrochemical cell. The power protection apparatus mainly includes a protection IC connected to the electrochemical cell, and a switching transistor group configured to turn on and turn off the electrochemical cell for protection.

The protection IC includes a power terminal VCC connected to a positive electrode of the electrochemical cell, a ground terminal GND connected to a negative electrode of the electrochemical cell, a positive current detection terminal, a negative current detection terminal, a current sampling detection output terminal, a discharge protection terminal DO, and a charge protection terminal CO. The power terminal VCC and the ground terminal GND are two power input terminals of the protection IC. The IC protection circuit includes an operational amplifier 100. The operational amplifier 100 includes a positive input pin connected to the positive current detection terminal, a negative input pin connected to the negative current detection terminal, and an output pin connected to the current sampling detection output terminal. The positive and negative electrodes of the electrochemical cell may be further connected to a filter capacitor, configured to filter an interference current and an interference voltage.

The switching transistor group is serially connected between the negative electrode of the electrochemical cell and the load, and includes a first connection terminal S₁ connected to the negative electrode of the electrochemical cell and a second connection terminal S₂ connected to the load. The switching transistor group further includes a discharge control terminal G1 configured to control turn-off of the switching transistor group during discharge, and a charge control terminal G2 configured to control turn-off of the switching transistor group during charge. The discharge control terminal G1 is correspondingly connected to the discharge protection terminal DO of the protection IC, and the charge control terminal G2 is correspondingly connected to the charge protection terminal CO of the protection IC.

The switching transistor group further includes a sampling circuit constituted by connecting X switching transistor units of a sampling part in parallel, and a main circuit constituted by connecting KX switching transistor units of a main circuit part in parallel, where X is an integer greater than or equal to 1, and K is a value greater than 1. Theoretically, to gain a relatively ideal effect, X needs to be set to a proper value. For example, if X is an integer greater than or equal to 1, for example, a value in [1, 10000], a value of X may be set to 100, 1000, 3000, 5000, or the like, and K is greater than or equal to 100, for example, K may be set to a value greater than 1, for example, 100, 500, 1000, 5000, or 10000. Theoretically, a larger value of K indicates higher accuracy, and KX is an integer. Specifically, comparison tests may be repeatedly performed based on a process, costs, and crystal or transistor characteristics to ensure that through-current impedance of the power protection apparatus is small enough and overcurrent protection precision is high enough. Equivalently, the first connection terminal S₁ and the second connection terminal S₂ are respectively connected to a charge-specific input terminal and output terminal of the main circuit part of the switching transistor group, or to a discharge-specific output terminal and input terminal of the main circuit part of the switching transistor group. In other words, the main circuit part of the switching transistor group is a part of a charge and discharge circuit of the electrochemical cell. A current in the charge and discharge circuit passes through the main circuit mainly through the first connection terminal S₁ and the second connection terminal S₂.

The switching transistor group further includes a sampling circuit detection terminal connected to a connection terminal of the sampling circuit, and a main circuit detection terminal connected to an input or output terminal of the main circuit. The main circuit detection terminal is connected to the positive input pin, and the sampling circuit detection terminal is connected to the negative input pin.

The sampling circuit detection terminal includes a sampling circuit output terminal SS₁, and the main circuit detection terminal includes a detection output terminal S₁ₖ connected to the main circuit. The sampling circuit output terminal SS₁ is connected to the negative input pin of the operational amplifier 100 by using the negative current detection terminal of the protection IC. The main circuit detection output terminal S₁ₖ is connected to the positive input pin of the operational amplifier 100 by using the positive current detection terminal of the protection IC.

The sampling circuit output terminal SS₁ is further connected to the output pin of the operational amplifier 100, and the output pin is connected to the current sampling detection output terminal of the protection IC. The power protection apparatus further includes a sampling detection resistor Rs. The sampling detection resistor Rs is serially connected between the sampling circuit output terminal SS₁ and the output pin of the operational amplifier 100, and is configured to generate a sampling detection current. The electrochemical cell, the switching transistor group, and the load constitute the charge and discharge circuit that is a main conductivity circuit for discharge or charge of the electrochemical cell.

Specially, referring to FIG. 3, according to the invention, to improve precision, the sampling circuit detection terminal further includes a sampling detection output terminal SS₁ₖ connected to the sampling circuit. The sampling circuit output terminal SS₁ is connected to only the output pin of the operational amplifier 100. The sampling detection output terminal SS₁ₖ is connected to the negative input pin of the operational amplifier 100, and the sampling detection resistor Rs is serially connected between the sampling circuit output terminal SS₁ and the output pin of the operational amplifier 100.

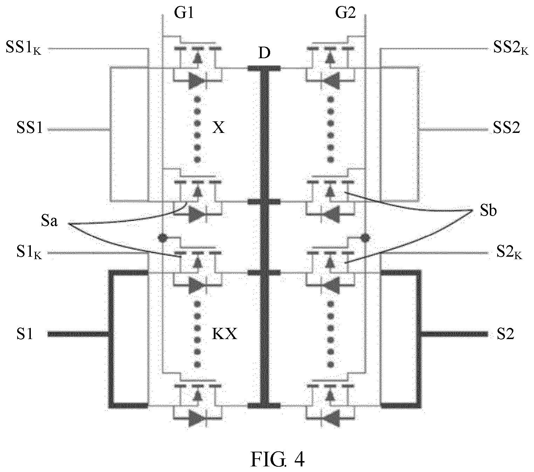

As shown in FIG. 4, the switching transistor group includes (X+KX) switching transistor units that are connected in parallel, where X MOS switching transistor units are connected in parallel to constitute the sampling circuit, KX MOS transistors are connected in parallel to constitute the main circuit, each switching transistor unit includes a first switching transistor Sa and a second switching transistor Sb that is serially connected to the Sa reversely, each Sa or SB is connected to a diode D1 in parallel, and one of the Sa and the Sb is a charge switching transistor and the other one is a discharge switching transistor. In this embodiment, for ease of description, the Sa is selected as the discharge switching transistor, and is turned on when the electrochemical cell is discharged and turned off when the electrochemical cell is charged; and the Sb is the charge switching transistor, and is turned on when the electrochemical cell is charged and turned off when the electrochemical cell is discharged. The D1 is configured to protect the Sa and the Sb, to prevent them from being broken down. The Sa and the Sb may be MOS transistors, or may be other semiconductor switching transistors having a similar characteristic.

The X switching transistor units are connected in parallel to constitute the sampling circuit, and the KX switching transistor units are connected in parallel to constitute the main circuit. D electrodes of Sa's and Sb's of the (X+KX) switching transistor units are connected together, G electrodes of the Sa's of the (X+KX) switching transistor units are connected together to constitute the discharge control terminal G1, and G electrodes of the Sb's of the (X+KX) switching transistor units are connected together to constitute the charge control terminal G2.

S electrodes of all Sa's of the X switching transistor units constituting the sampling circuit are connected to a same pin to constitute the sampling circuit output terminal SS₁. S electrodes of all Sb's of the X switching transistor units are connected to a same pin to constitute the sampling circuit output terminal SS₂.

Similar to the sampling circuit, S electrodes of all Sa's of the KX switching transistor units constituting the main circuit are connected to a same pin to constitute the first connection terminal S₁ of the switching transistor group, and S electrodes of all Sb's of the X switching transistor units are connected to a same pin to constitute the second connection terminal S₂ of the switching transistor group. To reduce impact of impedance of the pin itself and improve detection precision, the sampling detection output terminal SS₁ₖ of the switching transistor group may be constituted by directly connecting the S electrodes on wafers of all the Sa's of the X switching transistor units of the sampling circuit by using a high-conductivity metal wire. Similarly, another sampling detection output terminal SS₂ₖ of the switching transistor group may be constituted by directly connecting the S electrodes on wafers of all the Sb's of the X switching transistor units of the sampling circuit by using a high-conductivity metal.

Similar to the sampling circuit, the detection output terminal S₁ₖ of the main circuit may be constituted by directly connecting the S electrodes on wafers of all the Sa's of the KX switching transistor units of the main circuit by using a high-conductivity metal wire. Similarly, another detection output terminal S₂ₖ of the main circuit of the switching transistor group may be constituted by directly connecting the S electrodes on wafers of all the Sb's of the KX switching transistor units of the main circuit by using a high-conductivity metal.

The high-conductivity metal wire includes a high-conductivity gold wire, a high-conductivity silver wire, a high-conductivity copper wire, and the like, or may include some high-conductivity alloy conductors. A current does not need to pass through a pin, but is directly output from a wafer of the switching transistor group by using a high-conductivity metal wire, so that current detection precision is not affected by impedance of the pin itself.

In some examples, which are not part of the invention, when a detection precision requirement is not extremely high or detection precision can satisfy a need currently, the sampling detection output terminals SS₁ₖ and SS₂ₖ, and the main circuit detection output terminals S₁ₖ and S₂ₖ do not need to be led out of wafers of the transistors of the switching transistor group by using the high-conductivity metal wire, but various output terminals SS₁, SS₂, S₁, and S₂ constituted by pins of the switching transistor group are directly used. In addition, the main circuit detection terminal may be the first connection terminal S₁ connected to each Sa of the main circuit of the switching transistor group, and the second connection terminal Sb connected to each Sb of the main circuit of the switching transistor group.

In some embodiments, positions of the Sa and the Sb are interchangeable; and the operational amplifier 100 may alternatively be connected to the other side of the switching transistor group, that is, the operational amplifier 100 may be connected to the SS₂, the SS₂ₖ, and the S₂ₖ. Such a different connection manner does not cause changes to implementation principles and manners, and details are not described herein.

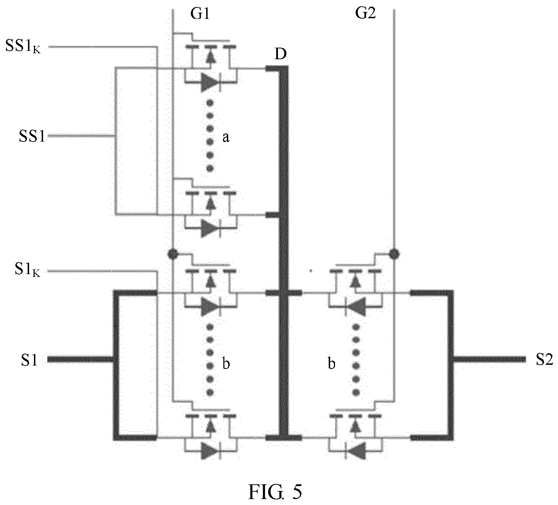

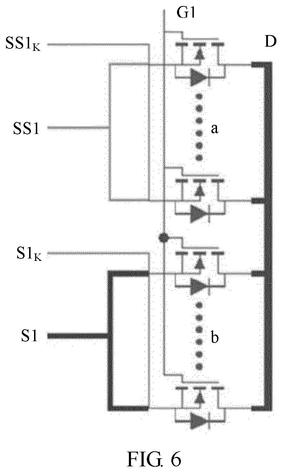

In some embodiments of the present invention, the switching transistor group is not limited to that each switching transistor unit includes both the Sa and the Sb, as shown in FIG. 4. As shown in FIG. 5, the switching transistor group is a unidirectional switching transistor group, and each switching transistor unit includes only one switching transistor to protect only charge or discharge of the electrochemical cell. Alternatively, as shown in FIG. 6, in some embodiments of the present invention, the switching transistor group is a bi-directional switching transistor group, but only each switching transistor unit of the main circuit part of the switching transistor group includes two switching transistors that are serially connected reversely, and each switching transistor unit of the sampling circuit part of the switching transistor group includes only one switching transistor. Therefore, the switching transistor group in this embodiment of the present invention is not limited to a specific structure design, and any switching transistor group that can implement an equal-proportion current imaging relationship when a voltage of the main circuit and a voltage of the sampling circuit are equal can be used as the switching transistor group in this embodiment of the present invention.

The operational amplifier 100 is configured to adjust the negative input pin and the positive input pin to obtain a same potential, that is, enable the sampling detection output terminal SS₁ₖ of the switching transistor group and the detection output terminal S₁ₖ of the main circuit to have a same potential. Various MOS transistor units constituting the switching transistor group are on a same wafer, the units are highly consistent, and temperature characteristics and impedance of the units are also consistent. Therefore, a voltage between the discharge control terminal G1 and the sampling detection output terminal SS₁ₖ of the switching transistor group is equal to a voltage between the discharge control terminal G1 and the detection output terminal S₁ₖ of the main circuit, and a voltage between a D electrode of a switching transistor of the sampling circuit and the SS₁ₖ is equal to a voltage between a D electrode of a switching transistor of the main circuit and the S₁ₖ, that is, V_{G1SS1k} = V_{G1S1K} and V_{DSS1k} = V_{DS1K}. A relationship between a resistance R_{DSS1k} between the D electrode of the switching transistor of the sampling circuit and the sampling detection output terminal SS₁ₖ and a resistance R_{DS1k} between the D electrode of the switching transistor of the main circuit and the main circuit output terminal S₁ₖ is R_{DSS1k}:R_{DS1k} = K:1. In other words, a ratio of impedance of the main circuit of the switching transistor group to impedance of the sampling circuit of the switching transistor group is equal to an inverse ratio of a quantity of parallel-connected MOS transistor units of the main circuit to a quantity of parallel-connected MOS transistor units of the sampling circuit, that is, 1/k.

When V_{G1SS1k} = V_{G1S1K}, R_{DSS1k}:R_{DS1k} is equal to K:1, a current of the sampling detection output terminal SS₁ₖ is I _{SS1K}, and a current of the main circuit output terminal S₁ₖ is I _{S1k}. In this case, I _{SS1k}:I _{S1k} = 1/1/(R_{DSS1k}:R_{DS1k}) = 1:K, or in other words, the current I _{SS1k} of the sampling circuit is an image current that is obtained by reducing the main circuit current I _{S1k} by K times. Therefore, after the current I _{SS1k} of the sampling circuit is detected, I _{S1k} may be obtained based on an imaging ratio coefficient K, that is, I _{S1k} = K*I _{SS1k}.

When K is large enough, for example, K is greater than or equal to 100, 1000, or 10000, I _{S1k} is basically equal to a current I_{S1} passing through the switching transistor group and the entire charge and discharge circuit, and I _{SS1k} is basically equal to a sampling circuit current passing through I _{SS1}. Therefore, I_{SS1}/I_{S1} = 1/K. The protection IC determines, based on a value of I _{S1k}, whether to send a turn-off signal to the discharge control terminal G1 and the charge control terminal G2 of the switching transistor group, to turn off the switching transistor group to stop charging or discharging the electrochemical cell.

Imaging principles of connection terminals led out of the Sb, for example, the S₂, the S₂ₖ, and SS₂ₖ, and the S₁, the S₁ₖ, and the SS₁ₖ, are the same.

When V_{G2SS2k} = V_{G2S2K}, R_{DSS2k}:R_{DS2k} is equal to K:1, a current of the sampling detection output terminal SS₂ₖ is I _{SS2k}, and a current of the main circuit output terminal S₂ₖ is I _{S2k}. In this case, I _{SS2k}:I _{S2k} = 1/1/(R_{DSS2k}:R_{DS2k}) = 1:K, or in other words, the current I _{SS2k} of the sampling circuit is an image current that is obtained by reducing the main circuit current I _{S2k} by K times. Therefore, after the current I _{SS1k} of the sampling circuit is detected, I _{S1k} may be obtained based on an imaging ratio coefficient K, that is, I _{S2k} = K*I _{SS2k}.

It can be understood that characteristics and working principles of the Sa and the Sb of the switching transistor group are exactly consistent, except that conductivity directions are inverse. For brevity, only key points are simply described herein, and specific implementation details are not provided.

In this embodiment of the present invention, charge overvoltage protection, discharge undervoltage protection, charge overcurrent protection, and discharge overcurrent protection of a battery are implemented by using the switching transistor group and the protection IC. A current imaging function of a detection field effect transistor is used to perform imaging on the current in the main through-current circuit based on a given proportional coefficient 1/K to obtain a very low current. The protection IC of the lithium-ion battery detects the very low current obtained through imaging, and then multiplies the very low current by a proportional coefficient K, to obtain a value of the current in the main through-current circuit. The sampling detection resistor Rs is serially connected between the sampling detection output terminal SS₁ₖ and the output pin, and is not disposed on the charge and discharge circuit. In addition, a detection current passing through the sampling detection resistor Rs is 1/K of the current in the charge and discharge circuit, far less than the current in the charge and discharge circuit. Therefore, heat generated by the sampling detection resistor Rs is very small, and basically has no actual impact on temperature of the charge and discharge circuit.

In addition, a current passing through the sampling detection output terminal SS₁ₖ and the sampling detection resistor Rs is far less than a current passing through the main circuit of the switching transistor group and the charge and discharge circuit. Therefore, although a value of the sampling detection resistor Rs is scores of ohms to hundreds of ohms, no loss having actual impact is generated on the sampling detection resistor Rs. In addition, the resistance value of the sampling detection resistor Rs is not affected by a factor such as heating, and therefore a proper resistance value can be selected to achieve highest detection precision.

Finally, whether charge overcurrent or discharge overcurrent occurs is determined based on the detection current, and then the protection IC turns off a charge switch or a discharge switch to implement a function of charge overcurrent protection or discharge overcurrent protection. In this way, high-precision charge overcurrent protection and discharge overcurrent protection can be implemented without disposing a current sampling resistor on a charge and discharge through-current circuit of a terminal, thereby greatly reducing impedance of the through-current circuit and effectively reducing heat emitted by the charge and discharge circuit.

In addition, based on the foregoing imaging detection current and the proper value of the sampling detection resistor Rs, precision of a reference voltage of a comparator, configured to determine overcurrent, of the power protection apparatus can reach X mV±2 mV, for example, 200 mV±2 mV. An error caused by the precision of the reference voltage of the comparator, configured to determine overcurrent, of the power protection apparatus is only 1%. For another example, an overcurrent protection design of implementing turn-off within 3.5 seconds (S) when a current reaches a threshold of 7±0.7 amperes (A) can satisfy a requirement that protection is enabled within 5s when a current is 8 A and turn-off protection is not enabled within 60s when a current is 5 A, within 5s when a current is 6 A, or within 2s when a current is 7 A. For 7 A, 0.7 A is precision of 10%. An error caused by precision of the protection IC in the error of 10% may be within 1%. An error caused by precision of the current sampling resistor may be within 1%, and an error caused by current imaging ratio precision of the MOS transistor group may be within 5%. In this way, an accumulated error is less than 10%.

When a voltage of a second terminal of the sampling detection resistor Rs, or in other words, an amplitude of a detected signal, is greater than the reference voltage of the comparator that is configured to determine overcurrent and that is of the protection IC, an output terminal of the comparator outputs a first level, to turn off the switching transistor group, which indicates that overcurrent occurs on the charge and discharge circuit and the switching transistor group; otherwise, a second level is output to keep conductivity of the switching transistor group, which indicates that no overcurrent occurs on the charge and discharge circuit or the switching transistor group.

In some embodiments, the power protection apparatus may be configured to protect a power supply or a component other than the electrochemical cell against a current or voltage abnormality. When a detection current of the power supply or the component is abnormal, for example, too high or too low, a protection measure such as turn-off, voltage reduction, or voltage increase is implemented.

### Embodiment 2

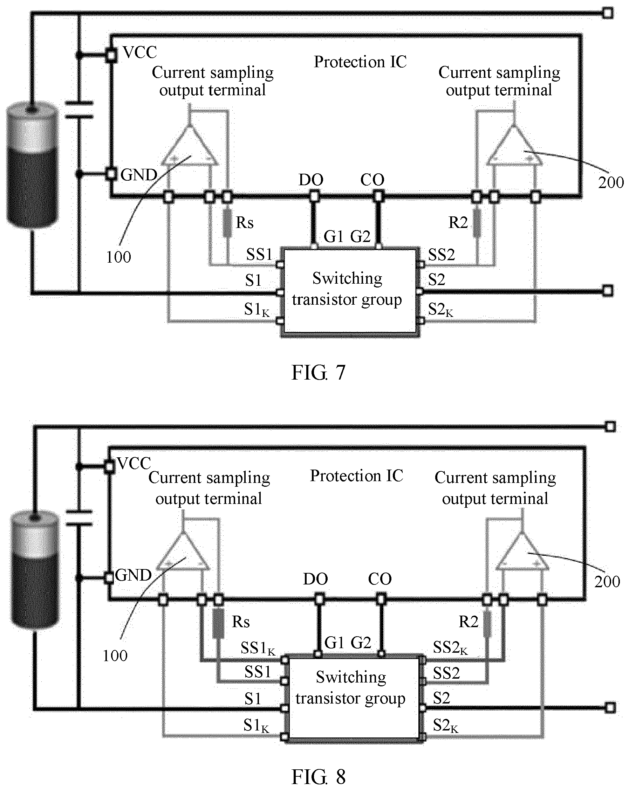

Embodiment 2 is disclosed in FIG. 8. FIG. 7 discloses an example, which is not part of the invention, but provides for better understanding of it. As shown in FIG. 7, a difference between a power protection apparatus in Embodiment 2 of the present invention and the power protection apparatus in Embodiment 1 of the present invention lies in: the power protection apparatus in Embodiment 1 has only one operational amplifier 100, and the operational amplifier 100 is connected to only an output terminal of a discharge switching transistor Sa of the switching transistor group; and in Embodiment 2, a secondary operational amplifier 200 is further included based on Embodiment 1, and the secondary operational amplifier 200 is connected to an output terminal of a charge switching transistor Sb of the switching transistor group. Specific details are as follows:

Based on Embodiment 1, the protection IC further includes a positive current detection terminal, a negative current detection terminal, and a current sampling detection output terminal.

The secondary operational amplifier 200 further includes a positive input pin connected to the positive current detection terminal, a negative input pin connected to the negative current detection terminal, and an output pin connected to the current sampling detection output terminal.

A sampling circuit output terminal SS₂ of the switching transistor group is connected to the negative input pin of the secondary operational amplifier 200 by using the negative current detection terminal of the protection IC, and a detection output terminal S₂ₖ of the main circuit is connected to the positive input pin of the secondary operational amplifier 200 by using the positive current detection terminal of the protection IC.

The sampling circuit output terminal SS₂ is connected to the output pin of the secondary operational amplifier 200, and the output pin is connected to the current sampling detection output terminal of the protection IC. The power protection apparatus further includes a sampling detection resistor Rs. The sampling detection resistor Rs is serially connected between the sampling circuit output terminal SS₂ of the switching transistor group and the output pin of the secondary operational amplifier 200, and is configured to generate a sampling detection current.

The secondary operational amplifier 200 in Embodiment 2 of the present invention is similar to the operational amplifier 100 in Embodiment 1 in connection, and a tiny difference has been described above. Principles of current detection and overcurrent protection of a charge and discharge circuit in Embodiment 2 of the present invention are completely the same as those in Embodiment 1, and details are not described herein again.

As shown in FIG. 8, according to the present invention, to improve precision, the sampling circuit output terminal SS₂ is connected to only the output pin of the secondary operational amplifier 200, the sampling detection output terminal SS₂ₖ is connected to the negative input pin of the secondary operational amplifier 200, and the sampling detection resistor Rs is serially connected between the sampling circuit output terminal SS₂ and the output pin of the secondary operational amplifier 200.

It can be understood that in some embodiments, the protection IC only has one secondary operational amplifier 200 that is connected to an output terminal of the charge switching transistor Sb of the switching transistor group. This can also implement the present invention. An image current is used as a sampling detection current to detect charge and discharge current values of the electrochemical cell, and turn-off of the switching transistor group is controlled based on the charge and discharge current values obtained through sampling detection and a comparison result of the comparator, to implement protection against abnormalities such as overcurrent and overheat of the electrochemical cell.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

## Claims

1. A power protection apparatus configured to protect an electrochemical cell connected to a load, comprising:
a protection IC, comprising two power input terminals respectively to be connected to positive and negative electrodes of the electrochemical cell, at least one charge and discharge protection terminal DO, CO, and an operational amplifier (100), wherein the operational amplifier comprises a positive input pin, a negative input pin, and an output pin;
a switching transistor group, to be connected between the negative electrode of the electrochemical cell and the load, and configured to turn on or turn off a circuit for charging and discharging the electrochemical cell, wherein the switching transistor group comprises a main circuit part of the switching transistor group and a sampling part of the switching transistor group; and the switching transistor group comprises a first connection terminal S1 to be connected to the negative electrode of the electrochemical cell, a second connection terminal S2 to be connected to the load, and at least one control terminal G1, G2, wherein the first connection terminal and the second connection terminal are respectively connected to a charging-specific input terminal and output terminal of the main circuit part of the switching transistor group, and the at least one control terminal G1, G2 is connected to the at least one charge and discharge protection terminal of the protection IC, and the at least one control terminal is configured to receive a control signal of the protection IC to control turn-off of the switching transistor group to implement protection against an abnormality of the electrochemical cell by cutting off the charge or discharge circuit of the electrochemical cell; and
a sampling detection resistor Rs, serially connected between the sampling part of the switching transistor group and the output pin, wherein the sampling detection resistor Rs is for detecting a current of the sampling part of the switching transistor group, wherein
the input terminal or the output terminal of the main circuit part of the switching transistor group is connected to the positive input pin, and a connection terminal of the sampling part of the switching transistor group is connected to the negative input pin; and
the switching transistor group comprises a sampling output terminal SS₁ connected to the connection terminal of the sampling part, and a main circuit detection output terminal S₁ₖ connected to the charging-specific input terminal of the main circuit part of the switching transistor group, the S₁ₖ is connected to the positive input pin of the operational amplifier (100), the SS₁ is connected to both the negative input pin and the output pin of the operational amplifier, and the sampling detection resistor Rs is serially connected between the SS₁ and the output pin of the operational amplifier; and
**characterized in that**
the switching transistor group comprises X+KX switching transistor units; X switching transistor units are connected in parallel to constitute the sampling part of the switching transistor group; KX switching transistor units are connected in parallel to constitute the main circuit part of the switching transistor group; and a ratio of the current passing through the sampling part of the switching transistor group to the current passing through the main circuit part of the switching transistor group is equal to a ratio of a quantity of switching transistor units of the sampling part of the switching transistor group to a quantity of switching transistor units of the main circuit part of the switching transistor group, that is, is equal to 1:K, wherein X is an integer greater than or equal to 1, K is greater than 1, and KX is an integer;
each switching transistor unit comprises a first switching transistor Sa;
S electrodes of all first switching transistors Sa of the X switching transistor units constituting the sampling part of the switching transistor group are connected to a same pin to constitute the sampling output terminal SS₁;
S electrodes of all first switching transistors Sa of the KX switching transistor units constituting the main circuit part of the switching transistor group are connected to a same pin to constitute the first connection terminal S₁ of the switching transistor group,
a sampling detection output terminal SS₁ₖ of the switching transistor group is constituted by directly connecting the S electrodes on wafers of all the first switching transistors Sa of the X switching transistor units of the sampling part of the switching transistor group by using a high-conductivity metal wire;
the main circuit detection output terminal S₁ₖ of the switching transistor group is constituted by directly connecting the S electrodes on wafers of all the first switching transistors Sa of the KX switching transistor units of the main circuit part of the switching transistor group by using a high-conductivity metal wire.

2. The power protection apparatus according to claim 1, wherein the operational amplifier (100) is configured to enable the negative input pin and the positive input pin to have a same potential, so that a current passing through the sampling part of the switching transistor group is equally proportional to a current passing through the main circuit part of the switching transistor group.

3. The power protection apparatus according to claim 1, wherein the switching transistor group further comprises a sampling output terminal SS₂ connected to the connection terminal of the sampling part, and a main circuit detection output terminal S₂ₖ connected to the charging-specific output terminal of the main circuit part, the protection IC further comprises a secondary operational amplifier (200), the S₂ₖ is connected to a positive input pin of the secondary operational amplifier, the SS₂ is connected to both a negative input pin and an output pin of the secondary operational amplifier, and the power protection apparatus further comprises a sampling detection resistor R2 that is serially connected between the SS₂ and the output pin of the secondary operational amplifier.

4. The power protection apparatus according to claim 1, wherein the sampling detection output terminal SS₁ₖ is connected to the connection terminal of the sampling part, and the SS₁ₖ is connected to the negative input pin of the operational amplifier.

5. The power protection apparatus according to claim 4, wherein the switching transistor group further comprises a sampling output terminal SS₂ and a sampling detection output terminal SS₂ₖ that are connected to the connection terminal of the sampling part, and a main circuit detection output terminal S₂ₖ connected to the charging-specific output terminal of the main circuit part of the switching transistor group, the protection IC further comprises a secondary operational amplifier (200), the S₂ₖ is connected to a positive input pin of the secondary operational amplifier, the SS₂ is connected to an output pin of the secondary operational amplifier, the SS₂ₖ is connected to a negative input pin of the secondary operational amplifier, and the power protection apparatus further comprises a sampling detection resistor R2 that is serially connected between the SS₂ and the output pin of the secondary operational amplifier.

6. The power protection apparatus according to claim 4 or 5, wherein each switching transistor unit further comprises a second switching transistor Sb that is serially connected to the first switching transistor Sa reversely, each Sa is connected to a diode D1 in parallel and each Sb is connected to a diode D1 in parallel, and one of the Sa and the Sb is a charge switching transistor and the other is a discharge switching transistor.

7. The power protection apparatus according to claim 6, wherein the at least one control terminal comprises a discharge control terminal G1 and a charge control terminal G2, D electrodes of all Sa's and Sb's of the X+KX switching transistor units are connected together, G electrodes of all Sa's of the X+KX switching transistor units are connected together to form the discharge control terminal G1, G electrodes of all Sb's of the X+KX switching transistor units are connected together to form the charge control terminal G2, S electrodes of all Sb's of the X switching transistor units are connected to a same pin to constitute the sampling output terminal SS₂, and S electrodes of all Sb's of the X switching transistor units are connected to a same pin to constitute the second connection terminal S2 of the switching transistor group.

8. The power protection apparatus according to claim 7, wherein the sampling detection output terminal SS₂ₖ is constituted by directly connecting the S electrodes on wafers of all the Sb's of the X switching transistor units of the sampling part of the switching transistor group by using a high-conductivity metal, and the main circuit detection output terminal S₂ₖ is constituted by directly connecting the S electrodes on wafers of all the Sb's of the KX switching transistor units of the main circuit part of the switching transistor group by using a high-conductivity metal.

9. The power protection apparatus according to any one of claims 1 to 6, wherein the at least one control terminal comprises a discharge control terminal G1 configured to control turn-off of the switching transistor group during discharge, and a charge control terminal G2 configured to control turn-off of the switching transistor group during charge, and the at least one charge and discharge protection terminal of the protection IC comprises a discharge protection terminal DO connected to the discharge control terminal G1, and a charge protection terminal CO connected to the charge control terminal G2.

10. A terminal, comprising a connector, a charge management chip, a battery, and a load, wherein the connector is configured to connect to a charge cable, the charge management chip is connected between the connector and the battery and is configured to control a charge process of the battery, the battery is configured to supply power to the load, and the battery comprises an electrochemical cell and the power protection apparatus according to any one of claims 1 to 9, wherein the power protection apparatus is configured to protect the electrochemical cell.

## Patentansprüche

1. Leistungsschutzeinrichtung, die konfiguriert ist, um eine elektrochemische Zelle, die mit einer Last verbunden ist, zu schützen, die umfasst:
einen Schutz-IC, der zwei Leistungseingangsanschlüsse, die mit einer positiven beziehungsweise einer negativen Elektrode der elektrochemischen Zelle zu verbinden sind, mindestens einen Lade- und Entladeschutzanschluss DO, CO, und einen Operationsverstärker (100) umfasst, wobei der Operationsverstärker einen positiven Eingangspin, einen negativen Eingangspin und einen Ausgangspin umfasst;
eine Schalttransistorgruppe, die zwischen der negativen Elektrode der elektrochemischen Zelle und der Last zu verbinden ist und konfiguriert ist, um einen Stromkreis zum Laden und Entladen der elektrochemischen Zelle einzuschalten oder auszuschalten, wobei die Schalttransistorgruppe ein Hauptstromkreisteil der Schalttransistorgruppe und ein Abtastteil der Schalttransistorgruppe umfasst; und die Schalttransistorgruppe einen ersten Verbindungsanschluss S1, der mit der negativen Elektrode der elektrochemischen Zelle zu verbinden ist, einen zweiten Verbindungsanschluss S2, der mit der Last zu verbinden ist, und mindestens einen Steueranschluss G1, G2, umfasst, wobei der erste Verbindungsanschluss und der zweite Verbindungsanschluss mit einem ladespezifischen Eingangsanschluss beziehungsweise Ausgangsanschluss des Hauptstromkreisteils der Schalttransistorgruppe verbunden sind, und der mindestens eine Steueranschluss G1, G2, mit dem mindestens einen Lade- und Entladeschutzanschluss des Schutz-IC verbunden ist, und der mindestens eine Steueranschluss konfiguriert ist, um ein Steuersignal des Schutz-IC zu empfangen, um ein Ausschalten der Schalttransistorgruppe zu steuern, um einen Schutz gegen eine Anomalie der elektrochemischen Zelle über ein Abschalten des Lade- oder Entladestromkreises der elektrochemischen Zelle implementieren; und
einen Abtasterfassungswiderstand Rs, der zwischen dem Abtastteil der Schalttransistorgruppe und dem Ausgangspin seriell verbunden ist, wobei der Abtasterfassungswiderstand Rs zum Erfassen eines Stroms des Abtastteils der Schalttransistorgruppe dient, wobei
der Eingangsanschluss oder der Ausgangsanschluss des Hauptstromkreisteils der Schalttransistorgruppe mit dem positiven Eingangspin verbunden ist, und ein Verbindungsanschluss des Abtastteils der Schalttransistorgruppe mit dem negativen Eingangspin verbunden ist; und
die Schalttransistorgruppe einen Abtastausgangsanschluss SS₁, der mit dem Verbindungsanschluss des Abtastteils verbunden ist, und einen Hauptstromkreiserfassungsausgangsanschluss S₁ₖ, der mit dem ladespezifischen Eingangsanschluss des Hauptstromkreises der Schalttransistorgruppe verbunden ist, umfasst, wobei der S₁ₖ mit dem positiven Eingangspin des Operationsverstärkers (100) verbunden ist, der SS₁ sowohl mit dem negativen Eingangspin als auch mit dem Ausgangspin des Operationsverstärkers verbunden ist und der Abtasterfassungswiderstand Rs zwischen den SS₁ und dem Ausgangspin des Operationsverstärkers seriell verbunden ist; und
**dadurch gekennzeichnet, dass**
die Schalttransistorgruppe X+KX Schalttransistoreinheiten umfasst; X Schalttransistoreinheiten parallel verbunden sind, um das Abtastteil der Schalttransistorgruppe zu bilden; KX Schalttransistoreinheiten parallel verbunden sind, um das Hauptstromkreisteil der Schalttransistorgruppe zu bilden; und ein Verhältnis des Stroms, der durch das Abtastteil der Schalttransistorgruppe fließt, zu dem Strom, der durch den Hauptstromkreisteil der Schalttransistorgruppe fließt, gleich einem Verhältnis einer Anzahl von Schalttransistoreinheiten des Abtastteils der Schalttransistorgruppe zu einer Anzahl von Schalttransistoreinheiten des Hauptstromkreisteils der Schalttransistorgruppe ist, das heißt, gleich 1 : K ist, wobei X eine ganze Zahl größer als oder gleich 1 ist, K größer als 1 ist und KX eine ganze Zahl ist;
jede Schalttransistoreinheit einen ersten Schalttransistor Sa umfasst;
S-Elektroden aller ersten Schalttransistoren Sa der X Schalttransistoreinheiten, die das Abtastteil der Schalttransistorgruppe bilden, mit einem gleichen Pin verbunden sind, um den Abtastausgangsanschluss SS₁ zu bilden;
S-Elektroden aller ersten Schalttransistoren Sa der KX Schalttransistoreinheiten, die das Hauptstromkreisteil der Schalttransistorgruppe bilden, mit einem gleichen Pin verbunden sind, um den ersten Verbindungsanschluss S1 der Schalttransistorgruppe zu bilden,
ein Abtasterfassungsausgangsanschluss SS₁ₖ der Schalttransistorgruppe ein direktes Verbinden der S-Elektroden auf Wafern aller ersten Schalttransistoren Sa der X Schalttransistoreinheiten des Abtastteils der Schalttransistorgruppe über ein Verwenden eines hochleitfähigen Metalldrahts gebildet wird;
der Hauptstromkreiserfassungsausgangsanschluss S₁ₖ der Schalttransistorgruppe über das direkte Verbinden der S-Elektroden auf Wafern aller ersten Schalttransistoren Sa der KX Schalttransistoreinheiten des Hauptstromkreisteils der Schalttransistorgruppe über das Verwenden eines hochleitfähigen Metalldrahts gebildet wird.

2. Leistungsschutzeinrichtung nach Anspruch 1, wobei der Operationsverstärker (100) konfiguriert ist, um zu ermöglichen, dass der negative Eingangspin und der positive Eingangspin ein gleiches Potenzial aufweisen, sodass ein Strom, der durch das Abtastteil der Schalttransistorgruppe fließt, gleich proportional zu einem Strom, der durch das Hauptstromkreisteil der Schalttransistorgruppe fließt, ist.

3. Leistungsschutzeinrichtung nach Anspruch 1, wobei die Schalttransistorgruppe ferner einen Abtastausgangsanschluss SS₂, der mit dem Verbindungsanschluss des Abtastteils verbunden ist, und einen Hauptstromkreiserfassungsausgangsanschluss S₂ₖ, der mit dem ladespezifischen Ausgangsanschluss des Hauptstromkreisteils verbunden ist, umfasst, der Schutz-IC ferner einen sekundären Operationsverstärker (200) umfasst, der S₂ₖ mit einem positiven Eingangspin des sekundären Operationsverstärkers verbunden ist, der SS₂ sowohl mit einem negativen Eingangspin als auch einem Ausgangspin des sekundären Operationsverstärkers verbunden ist, und die Leistungsschutzeinrichtung ferner einen Abtasterfassungswiderstand R2, der zwischen dem SS₂ und dem Ausgangspin des sekundären Operationsverstärkers seriell verbunden ist, umfasst.

4. Leistungsschutzeinrichtung nach Anspruch 1, wobei der Abtasterfassungsausgangsanschluss SS₁ₖ mit dem Verbindungsanschluss des Abtastteils verbunden ist und der SS₁ₖ mit dem negativen Eingangspin des Operationsverstärkers verbunden ist.

5. Leistungsschutzeinrichtung nach Anspruch 4, wobei die Schalttransistorgruppe ferner einen Abtastausgangsanschluss SS₂und einen Abtasterfassungsausgangsanschluss SS₂ₖ, die mit dem Verbindungsanschluss des Abtastteils verbunden sind, und einen Hauptstromkreiserfassungsausgangsanschluss S₂ₖ, der mit dem ladespezifischen Ausgangsanschluss des Hauptstromkreisteils der Schalttransistorgruppe verbunden ist, umfasst, der Schutz-IC ferner einen sekundären Operationsverstärker (200) umfasst, der S₂ₖ mit einem positiven Eingangspin des sekundären Operationsverstärkers verbunden ist, der SS₂ mit einem Ausgangspin des sekundären Operationsverstärkers verbunden ist, der SS₂ₖ mit einem negativen Eingangspin des sekundären Operationsverstärkers verbunden ist und die Leistungsschutzeinrichtung ferner einen Abtasterfassungswiderstand R2, der zwischen dem SS₂ und dem Ausgangspin des sekundären Operationsverstärkers seriell verbunden ist, umfasst.

6. Leistungsschutzeinrichtung nach Anspruch 4 oder 5, wobei jede Schalttransistoreinheit ferner einen zweiten Schalttransistor Sb, der mit dem ersten Schalttransistor Sa umgekehrt seriell verbunden ist, umfasst, jeder Sa mit einer Diode D1 parallel verbunden ist und jeder Sb mit einer Diode D1 parallel verbunden ist, und einer von dem Sa und dem Sb ein Ladeschalttransistor ist und der andere ein Entladeschalttransistor ist.

7. Leistungsschutzeinrichtung nach Anspruch 6, wobei der mindestens eine Steueranschluss einen Entladesteueranschluss G1 und einen Ladesteueranschluss G2 umfasst, D-Elektroden aller Sas und Sbs der X+KX Schalttransistoreinheiten miteinander verbunden sind, G-Elektroden aller Sas der X+KX Schalttransistoreinheiten miteinander verbunden sind, um den Entladesteueranschluss G1 auszubilden, G-Elektroden aller Sbs der X+KX Schalttransistoreinheiten miteinander verbunden sind, um den Ladesteueranschluss G2 auszubilden, S-Elektroden aller Sbs der X Schalttransistoreinheiten mit einem gleichen Pin verbunden sind, um den Abtastausgangsanschluss SS₂ zu bilden, und S-Elektroden aller Sbs der X Schalttransistoreinheiten mit einem gleichen Pin verbunden sind, um den zweiten Verbindungsanschluss S2 der Schalttransistorgruppe zu bilden.

8. Leistungsschutzeinrichtung nach Anspruch 7, wobei der Abtasterfassungsausgangsanschluss SS₂ₖ über das direkte Verbinden der S-Elektroden auf Wafern aller Sbs der X Schalttransistoreinheiten des Abtastteils der Schalttransistorgruppe über das Verwenden eines hochleitfähigen Metalls gebildet wird, und der Hauptstromkreiserfassungsausgangsanschluss S₂ₖ über das direkte Verbinden der S-Elektroden auf Wafern aller Sbs der KX Schalttransistoreinheiten des Hauptstromkreisteils der Schalttransistorgruppe über das Verwenden eines hochleitfähigen Metalls gebildet wird.

9. Leistungsschutzeinrichtung nach einem der Ansprüche 1 bis 6, wobei der mindestens eine Steueranschluss einen Entladesteueranschluss G1, der konfiguriert ist, um das Ausschalten der Schalttransistorgruppe während des Entladens zu steuern, und einen Ladesteueranschluss G2, der konfiguriert ist, um das Ausschalten der Schalttransistorgruppe während des Ladens zu steuern, umfasst, und der mindestens eine Lade- und Entladeschutzanschluss des Schutz-IC einen Entladeschutzanschluss DO, der mit dem Entladesteueranschluss G1 verbunden ist, und einen Ladeschutzanschluss CO, der mit dem Ladesteueranschluss G2 verbunden ist, umfasst.

10. Endgerät, umfassend einen Verbinder, einen Lademanagementchip, eine Batterie und eine Last, wobei der Verbinder konfiguriert ist, um mit einem Ladekabel verbunden zu werden, der Lademanagementchip zwischen dem Verbinder und der Batterie verbunden ist und konfiguriert ist, um einen Ladeprozess der Batterie zu steuern, die Batterie konfiguriert ist, um die Last mit Leistung zu versorgen, und die Batterie eine elektrochemische Zelle und die Leistungsschutzeinrichtung nach einem der Ansprüche 1 bis 9 umfasst, wobei die Leistungsschutzeinrichtung konfiguriert ist, um die elektrochemische Zelle zu schützen.

## Revendications

1. Appareil de protection de puissance configuré pour protéger une cellule électrochimique connectée à une charge, comprenant :
un CI de protection, comprenant deux bornes d'entrée de puissance respectivement à connecter à des électrodes positive et négative de la cellule électrochimique, au moins une borne de protection de charge et de décharge DO, CO, et un amplificateur opérationnel (100), dans lequel l'amplificateur opérationnel comprend une broche d'entrée positive, une broche d'entrée négative et une broche de sortie ;
un groupe de transistors de commutation, à connecter entre l'électrode négative de la cellule électrochimique et la charge, et configuré pour activer ou désactiver un circuit pour une charge et une décharge de la cellule électrochimique, dans lequel le groupe de transistors de commutation comprend une partie de circuit principal du groupe de transistors de commutation et une partie d'échantillonnage du groupe de transistors de commutation ; et le groupe de transistors de commutation comprend une première borne de connexion S1 à connecter à l'électrode négative de la cellule électrochimique,
une seconde borne de connexion S2 à connecter à la charge, et au moins une borne de commande G1, G2, dans lequel la première borne de connexion et la seconde borne de connexion sont respectivement connectées à une borne d'entrée et à une borne de sortie spécifiques à la charge de la partie de circuit principal du groupe de transistors de commutation, et l'au moins une borne de commande G1, G2 est connectée à l'au moins une borne de protection de charge et de décharge du CI de protection, et l'au moins une borne de commande est configurée pour recevoir un signal de commande du CI de protection afin de commander la désactivation du groupe de transistors de commutation pour mettre en œuvre une protection contre une anomalie de la cellule électrochimique en coupant le circuit de charge ou de décharge de la cellule électrochimique ; et
une résistance de détection d'échantillonnage Rs, connectée en série entre la partie d'échantillonnage du groupe de transistors de commutation et la broche de sortie, dans lequel la résistance de détection d'échantillonnage Rs est destinée à détecter un courant de la partie d'échantillonnage du groupe de transistors de commutation, dans lequel la borne d'entrée ou la borne de sortie de la partie de circuit principal du groupe de transistors de commutation est connectée à la broche d'entrée positive, et une borne de connexion de la partie d'échantillonnage du groupe de transistors de commutation est connectée à la broche d'entrée négative ; et
le groupe de transistors de commutation comprend une borne de sortie d'échantillonnage SS₁ connectée à la borne de connexion de la partie d'échantillonnage, et une borne de sortie de détection de circuit principal S₁ₖ connectée à la borne d'entrée spécifique à la charge de la partie de circuit principal du groupe de transistors de commutation, la S₁ₖ est connectée à la broche d'entrée positive de l'amplificateur opérationnel (100), la SS₁ est connectée à la fois à la broche d'entrée négative et à la broche de sortie de l'amplificateur opérationnel, et la résistance de détection d'échantillonnage Rs est connectée en série entre la SS₁ et la broche de sortie de l'amplificateur opérationnel ; et
**caractérisé en ce que**
le groupe de transistors de commutation comprend X + KX unités de transistors de commutation ; X unités de transistors de commutation sont connectées en parallèle pour constituer la partie d'échantillonnage du groupe de transistors de commutation ;
KX unités de transistors de commutation sont connectées en parallèle pour constituer la partie de circuit principal du groupe de transistors de commutation ; et un rapport du courant passant à travers la partie d'échantillonnage du groupe de transistors de commutation au courant passant à travers la partie de circuit principal du groupe de transistors de commutation est égal à un rapport d'une quantité d'unités de transistors de commutation de la partie d'échantillonnage du groupe de transistors de commutation à une quantité d'unités de transistors de commutation de la partie de circuit principal du groupe de transistors de commutation, c'est-à-dire, est égal à 1:K, dans lequel X représente un nombre entier supérieur ou égal à 1, K est supérieur à 1, et KX représente un nombre entier ;
chaque unité de transistors de commutation comprend un premier transistor de commutation Sa ;
S électrodes de tous les premiers transistors de commutation Sa des X unités de transistors de commutation constituant la partie d'échantillonnage du groupe de transistors de commutation sont connectées à une même broche pour constituer la borne de sortie d'échantillonnage SS₁ ;
S électrodes de tous les premiers transistors de commutation Sa des KX unités de transistors de commutation constituant la partie de circuit principal du groupe de transistors de commutation sont connectées à une même broche pour constituer la première borne de connexion S1 du groupe de transistors de commutation,
une borne de sortie de détection d'échantillonnage SS₁ₖ du groupe de transistors de commutation est constituée par la connexion directe des S électrodes sur des tranches de tous les premiers transistors de commutation Sa des X unités de transistors de commutation de la partie d'échantillonnage du groupe de transistors de commutation à l'aide d'un fil métallique à haute conductivité ;
la borne de sortie de détection de circuit principal S₁ₖ du groupe de transistors de commutation est constituée par la connexion directe des S électrodes sur des tranches de tous les premiers transistors de commutation Sa des KX unités de transistors de commutation de la partie de circuit principal du groupe de transistors de commutation à l'aide d'un fil métallique à haute conductivité.

2. Appareil de protection de puissance selon la revendication 1, dans lequel l'amplificateur opérationnel (100) est configuré pour permettre à la broche d'entrée négative et à la broche d'entrée positive d'avoir un même potentiel, de sorte qu'un courant passant à travers la partie d'échantillonnage du groupe de transistors de commutation est également proportionnel à un courant passant à travers la partie de circuit principal du groupe de transistors de commutation.

3. Appareil de protection de puissance selon la revendication 1, dans lequel le groupe de transistors de commutation comprend en outre une borne de sortie d'échantillonnage SS₂ connectée à la borne de connexion de la partie d'échantillonnage, et une borne de sortie de détection de circuit principal S₂ₖ connectée à la borne de sortie spécifique à la charge de la partie de circuit principal, le CI de protection comprend en outre un amplificateur opérationnel secondaire (200), la S₂k est connectée à une broche d'entrée positive de l'amplificateur opérationnel secondaire, la SS₂ est connectée à la fois à une broche d'entrée négative et à une broche de sortie de l'amplificateur opérationnel secondaire, et l'appareil de protection de puissance comprend en outre une résistance de détection d'échantillonnage R2 qui est connectée en série entre la SS₂ et la broche de sortie de l'amplificateur opérationnel secondaire.

4. Appareil de protection de puissance selon la revendication 1, dans lequel la borne de sortie de détection d'échantillonnage SS₁ₖ est connectée à la borne de connexion de la partie d'échantillonnage, et la SS₁ₖ est connectée à la broche d'entrée négative de l'amplificateur opérationnel.

5. Appareil de protection de puissance selon la revendication 4, dans lequel le groupe de transistors de commutation comprend en outre une borne de sortie d'échantillonnage SS₂ et une borne de sortie de détection d'échantillonnage SS₂ₖ qui sont connectées à la borne de connexion de la partie d'échantillonnage, et une borne de sortie de détection de circuit principal S₂ₖ connectée à la borne de sortie spécifique à la charge de la partie de circuit principal du groupe de transistors de commutation, le CI de protection comprend en outre un amplificateur opérationnel secondaire (200), la S₂ₖ est connectée à une broche d'entrée positive de l'amplificateur opérationnel secondaire, la SS₂ est connectée à une broche de sortie de l'amplificateur opérationnel secondaire, la SS₂ₖ est connectée à une broche d'entrée négative de l'amplificateur opérationnel secondaire, et l'appareil de protection de puissance comprend en outre une résistance de détection d'échantillonnage R2 qui est connectée en série entre la SS₂ et la broche de sortie de l'amplificateur opérationnel secondaire.

6. Appareil de protection de puissance selon la revendication 4 ou 5, dans lequel chaque unité de transistors de commutation comprend en outre un second transistor de commutation Sb qui est connecté en série au premier transistor de commutation Sa de manière inverse, chaque Sa est connecté à une diode D1 en parallèle et chaque Sb est connecté à une diode D1 en parallèle, et l'un parmi le Sa et le Sb est un transistor de commutation de charge et l'autre est un transistor de commutation de décharge.

7. Appareil de protection de puissance selon la revendication 6, dans lequel l'au moins une borne de commande comprend une borne de commande de décharge G1 et une borne de commande de charge G2, D électrodes de tous les Sa et les Sb des X + KX unités de transistors de commutation sont connectées ensemble, G électrodes de tous les Sa des X + KX unités de transistors de commutation sont connectées ensemble pour former la borne de commande de décharge G1, G électrodes de tous les Sb des X + KX unités de transistors de commutation sont connectées ensemble pour former la borne de commande de charge G2, S électrodes de tous les Sb des X unités de transistors de commutation sont connectées à une même broche pour constituer la borne de sortie d'échantillonnage SS₂, et S électrodes de tous les Sb des X unités de transistors de commutation sont connectées à une même broche pour constituer la seconde borne de connexion S2 du groupe de transistors de commutation.

8. Appareil de protection de puissance selon la revendication 7, dans lequel la borne de sortie de détection d'échantillonnage SS₂ₖ est constituée par la connexion directe des S électrodes sur des tranches de tous les Sb des X unités de transistors de commutation de la partie d'échantillonnage du groupe de transistors de commutation à l'aide d'un métal à haute conductivité, et la borne de sortie de détection de circuit principal S₂ₖ est constituée par la connexion directe des S électrodes sur des tranches de tous les Sb des KX unités de transistors de commutation de la partie de circuit principal du groupe de transistors de commutation à l'aide d'un métal à haute conductivité.

9. Appareil de protection de puissance selon l'une quelconque des revendications 1 à 6, dans lequel l'au moins une borne de commande comprend une borne de commande de décharge G1 configurée pour commander la désactivation du groupe de transistors de commutation pendant la décharge, et une borne de commande de charge G2 configurée pour commander la désactivation du groupe de transistors de commutation pendant la charge, et l'au moins une borne de protection de charge et de décharge du CI de protection comprend une borne de protection de décharge DO connectée à la borne de commande de décharge G1, et une borne de protection de charge CO connectée à la borne de commande de charge G2.

10. Terminal, comprenant un connecteur, une puce de gestion de charge, une batterie, et une charge, dans lequel le connecteur est configuré pour se connecter à un câble de charge, la puce de gestion de charge est connectée entre le connecteur et la batterie et est configurée pour commander un processus de charge de la batterie, la batterie est configurée pour alimenter la charge en énergie, et la batterie comprend une cellule électrochimique et l'appareil de protection de puissance selon l'une quelconque des revendications 1 à 9, dans lequel l'appareil de protection de puissance est configuré pour protéger la cellule électrochimique.
